# EUROPEAN PATENT APPLICATION

(11) **EP 2 480 061 A2**
(43) Date of publication of application: **25.07.2012**
(21) Application number: 11191092.3
(22) Date of filing: 29.11.2011
(51) Int. Cl.: H05K 13/04

(54) **Computing device calculating setting of part-mounting device, part-mounting device, and program**

(30) Priority: 24.01.2011 JP 2011012135
(71) Applicant: Hitachi High-Tech Instruments Co., Ltd., Saitama (JP)
(72) Inventor: Asakura, Ryoji, Tokyo (JP); Tateishi, Jun, Tokyo (JP); Hoshino, Masahiro, Saitama (JP); Moriya, Yuji, Saitama (JP)
(74) Representative: Calderbank, Thomas Roger

(57) **Abstract**

A technology relating to a part-mounting device and capable of reducing an anomaly incidence rate by using information about parts and nozzles to determine a nozzle for use in sucking a part and suitably calculate a motion acceleration or the like of a portion of a head or the like is provided. With the use of information about parts and nozzles (nozzle candidates) , when using a nozzle type for sucking a part, the part-mounting device (computing device) uses a ratio between a mass of the part and an area of a suction hole of the nozzle to calculate a motion acceleration or the like of a portion of the part-mounting device.

## Description

The present invention relates to technologies regarding production of electronic devices such as portable phones, personal computers, and television sets, the technologies including a device (a part-mounting device) that mounts parts (electronic parts) on a substrate (a circuit board). In particular, the present invention relates to a technology of performing computation (information processing) for determining settings for operation control for a portion (such as a mount head or a suction nozzle) of the part-mounting device.

In a part-mounting device, a part held by a part-supplying device (a feeder) is sucked by a suction nozzle (hereinafter also referred to as a "nozzle") of a placing head (hereinafter also referred to as a "head"), and is transferred to a predetermined position on a substrate for placement (this operation in combination of suction and placement is hereinafter referred to as mounting) . In this part-mounting device, the type of the nozzle for use in suction and the motion acceleration or the motion speed of the head or a beam on which the nozzle is mounted is required to be appropriately set according to the type and weight of the part being held by the feeder.

For example, when the weight of the part or the motion acceleration or the motion speed of the head or the like is large compared with the suction force of the nozzle, the inertial force of the part and air resistance may be larger than the suction force, thereby causing an anomaly such as a drop of the part from the nozzle and causing a defect in the substrate. For this reason, replacement by a nozzle with a larger suction force and adjustment of the motion acceleration and others of the head or the like are required.

In order not to cause an anomaly (or to decrease an anomaly incidence rate) as described above, the type of the nozzle and the motion acceleration or the like of the head or the like are required to be appropriately determined (for example, be calculated by computation) so that the suction force of the nozzle exceeds the inertial force and air resistance.

Regarding the point described above, Japanese Patent Application Laid-Open Publication No. 2009-170531 (hereinafter referred to as Patent Document 1) and Japanese Patent No. 4100470 (hereinafter referred to as Patent Document 2) have been suggested as conventional-art examples.

Patent Document 1 describes a technology such that, in a part-mounting device, a ratio at which anomalies have occurred (an anomaly occurrence ratio) for each of suction nozzles of a plurality of types is stored for each part type, and the nozzle of the type with a low anomaly occurrence ratio is prioritized for use, thereby decreasing a ratio of occurrence of anomalies.

Patent Document 2 relates to a movement control method for a part-sucking member with respect to a circuit board and determination of an allowable acceleration and deceleration, describing that allowable accelerations and decelerations for each of a plurality of parts is calculated from the mass, height, bottom area, and others of each part.

In conventional-art examples such as Patent Documents 1 and 2 described above, problems as described below arise.

In the technology of Patent Document 1, an anomaly incidence rate (for example, a ratio of dropping of a part) is stored for each combination of a part type and a nozzle type. When a part of one part type is mounted, a nozzle type with a low anomaly incidence rate is prioritized for use. However, in the technology of Patent Document 1, it is impossible to calculate a motion acceleration or motion speed of the head or the beam with the part type and the nozzle type being taken as input information (such function is not provide). For this reason, even if the anomaly incidence rate can be decreased by decreasing the motion acceleration or the like, the motion acceleration or the like cannot be corrected, and therefore the anomaly incidence rate cannot be decreased.

In the technology of Patent Document 2, the area of a contact surface of the nozzle (the bottom area of the part) is used to calculate the motion acceleration. In the technology of Patent Document 2, however, the motion acceleration is not calculated by using the size of the suction hole area of the nozzle. Therefore, even if the part is sucked strongly by the nozzle, the operation cannot be made with large motion acceleration. Moreover, in Patent Document 2, expressions for use in calculation of the motion acceleration are not corrected by using information about anomalies occurring at the time of mounting, and therefore accuracy cannot be increased.

In view of the above, a main preferred aim of the present invention relates to a part-mounting device (determination of its operation and settings), and the main preferred aim is to provide a technology capable of reducing an anomaly incidence rate by using part types, nozzle types, and others as input information to suitably calculate and determine a nozzle type for use and a motion acceleration, a motion speed, or the like of a portion (such as a head or a beam) of the part-mounting device.

A typical embodiment of the present invention is directed to a computing device performing computation (information processing) for determining settings (their information) of operation control of a part-mounting device and a part-mounting device including the computing device, and others, and has a feature having the following structure.
(1) The computing device of the present invention has a processing function of using part information (including information about the shape, dimensions (such as width, length, thickness, or volume), mass (m), and others of a part or a part type) and nozzle information (including information about the area (s) and the shape such as a diameter of a suction hole of a nozzle or a nozzle type as a candidate) as input information to calculate a nozzle or a nozzle type for use in mounting (sucking) the part or the part type and a motion acceleration (a) (or a motion speed) or the like of a portion such as a head associated with the operation of the part and the nozzle and setting the information obtained by calculation to the part-mounting device.

For example, as information for settings for operation control of the part-mounting device, the computing device determines a correspondence among a part (such as a mass), a nozzle (such as a shape), a motion acceleration (a), and others and stores the information in a storage unit.

For example, when a plurality of nozzles as candidates for use in mounting are presented for a target part, with the use of the part information and the nozzle information, the computing device performs a process of using a comparison (difference) between part dimensions and a diameter of nozzle suction hole to determine availability of each nozzle, and a process of using a comparison (ratio) between the part mass (m) and the nozzle suction hole area (s) to determine availability of each nozzle.

For example, the computing device performs a process of using a comparison (an area-to-mass ratio: s/m) between the part mass (m) and the nozzle suction hole area (s) to calculate a motion acceleration (a) or the like of a portion such as a head corresponding to the nozzle when the nozzle is used for sucking the part.

For example, the computing device performs a process of selecting a nozzle for mounting based on the result of determination as to availability of the nozzle candidate and the calculated motion acceleration (a) or the like and updating the information for the settings.
(2) Furthermore, the computing device has a processing function of using information about parts previously mounted (mounted parts) and nozzles used correspondingly (such as a part mass (m), a motion acceleration (a), and an anomaly incidence rate) to correct (update) values for settings, for example, values of information (such as a motion acceleration (a)) about a new part and its corresponding nozzle, in consideration of an anomaly incidence rate or the like.
(3) For example, a part-mounting device can handle a plurality of nozzles and nozzle types and a plurality of parts and part types, and controls an operation of causing a part to be sucked by a nozzle and mounting the part on a substrate, according to information determined by a computing device. The computing device has a control unit computing information for the operation control and settings and a storage unit storing data information for use in the computation. The storage unit stores part information including information about a mass (m) of a part or a part type and others and nozzle information including information about an area (s) of a suction hole of a nozzle or a nozzle type for use in mounting (sucking) a part or a part type. Based on the information in the storage unit, for each nozzle or nozzle type and each part or part type, the control unit performs a processing of using a ratio (s/m) between the area (s) of a suction hole of the nozzle or the nozzle type and the mass (m) of the part or the part type and others to calculate a motion acceleration (a) or the like of a portion (such as a head) of the part-mounting device associated with the operation of the nozzle when the part or the part type is mounted (sucked) by using the nozzle or the nozzle type.

According to a typical embodiment of the present invention, the present invention relates to a part-mounting device and, with the use of information about part types and nozzle types as input information, determines a nozzle type for use and suitably calculates a motion acceleration or the like of a portion of the part-mounting device, thereby reducing an anomaly incidence rate.

In the drawings:
FIG. 1 is a diagram illustrating an example of structure of a part-mounting device according to an embodiment of the present invention;
FIG. 2 is a diagram illustrating an example of structure of a computing device according to an embodiment of the present invention;
FIG. 3 is a diagram schematically illustrating an example of structure of portions such as a feeder and a head in the part-mounting device and an example of structure of part-mounting onto a substrate;
FIG. 4 is a diagram illustrating an example of structure of a lower surface of the head;
FIG. 5 is a diagram illustrating an example of structure of a lower surface of a nozzle;
FIG. 6 is a flowchart illustrating a mount-setting calculating processing in the computing device;
FIG. 7 is a flowchart illustrating a learning processing in the computing device;
FIG. 8 is a diagram illustrating an example of a table for mount information;
FIG. 9 is a diagram illustrating an example of a table for suction nozzle information;
FIG. 10 is a diagram illustrating an example of a table for part information;
FIG. 11 is a diagram illustrating an example of a table for information of a shape of the suction nozzle;
FIG. 12 is a diagram illustrating an example of a table for area-to-mass-ratio acceleration information;
FIG. 13 is a diagram illustrating an example of a table for density information;
FIG. 14 is a diagram illustrating an example of a table for new part information;
FIG. 15 is a diagram illustrating an example of a table for suction-nozzle candidate information;
FIG. 16 is a diagram illustrating an example of a table for data ratio information;
FIG. 17 is a diagram illustrating an example of a first screen (an input screen for new part information);
FIG. 18 is a diagram illustrating an example of a second screen (an output screen for mount settings); and
FIG. 19 is a diagram illustrating an example of a third screen (an input screen for learning setting value information).

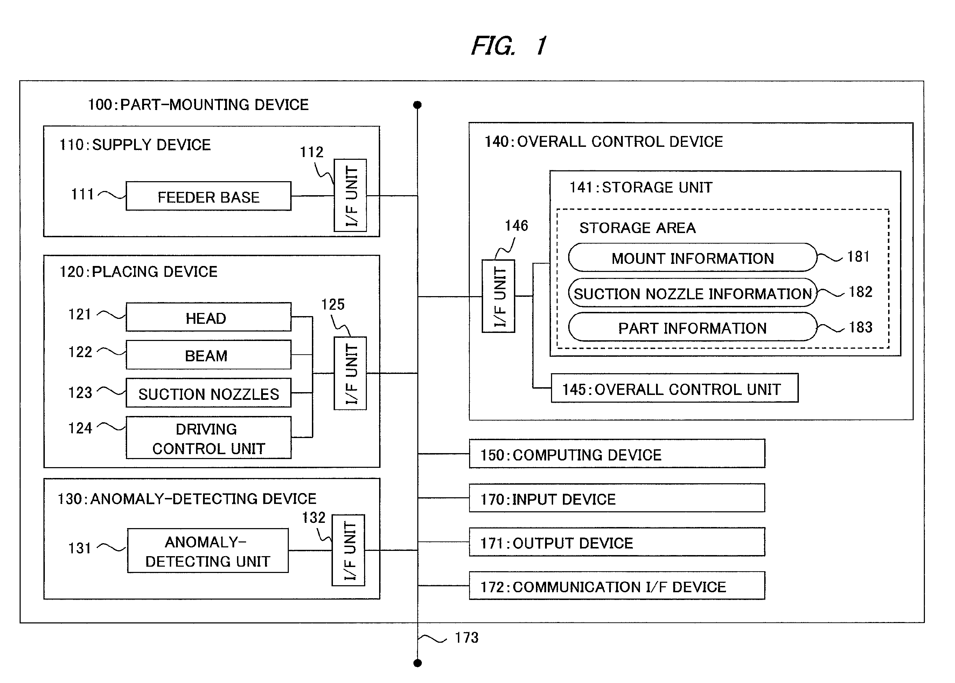

An embodiment (such as a computing device and a part-mounting device) of the present invention is described below with reference to FIGs. 1 to 19. Note that components having the same function are denoted by the same reference symbols throughout the drawings for describing the embodiment, and the repetitive description thereof will be omitted.

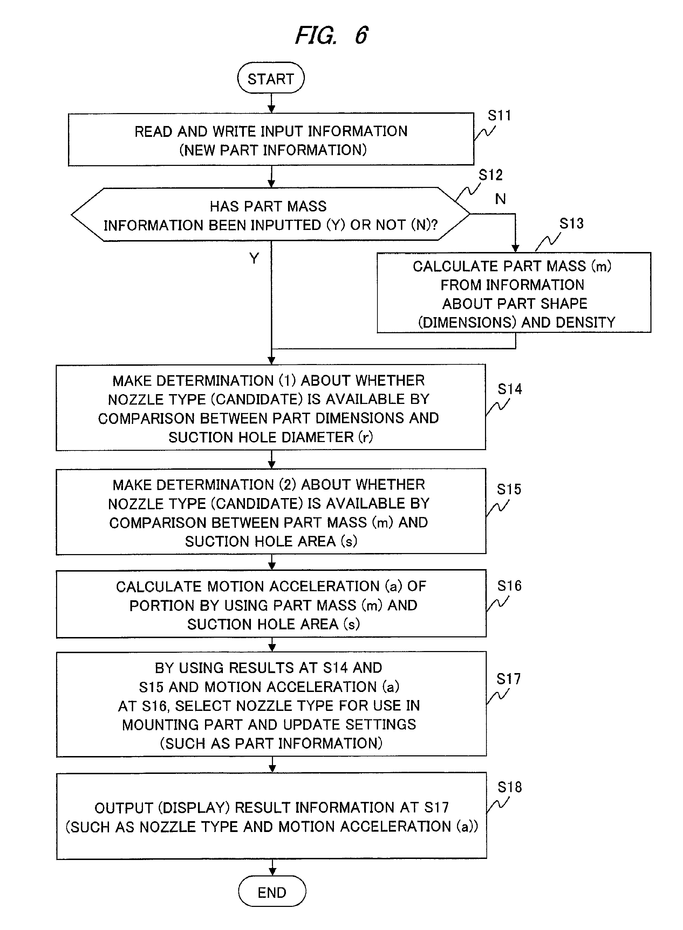

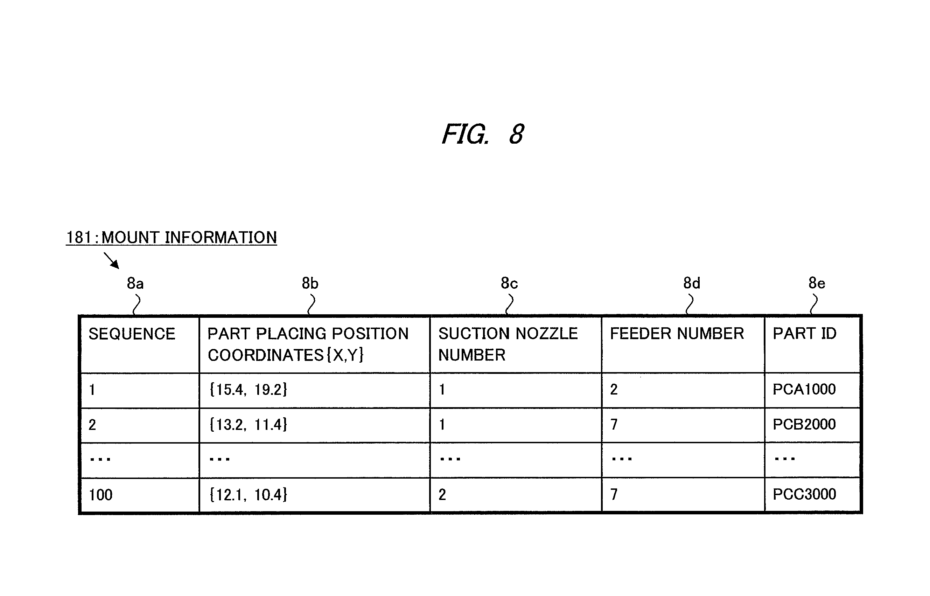

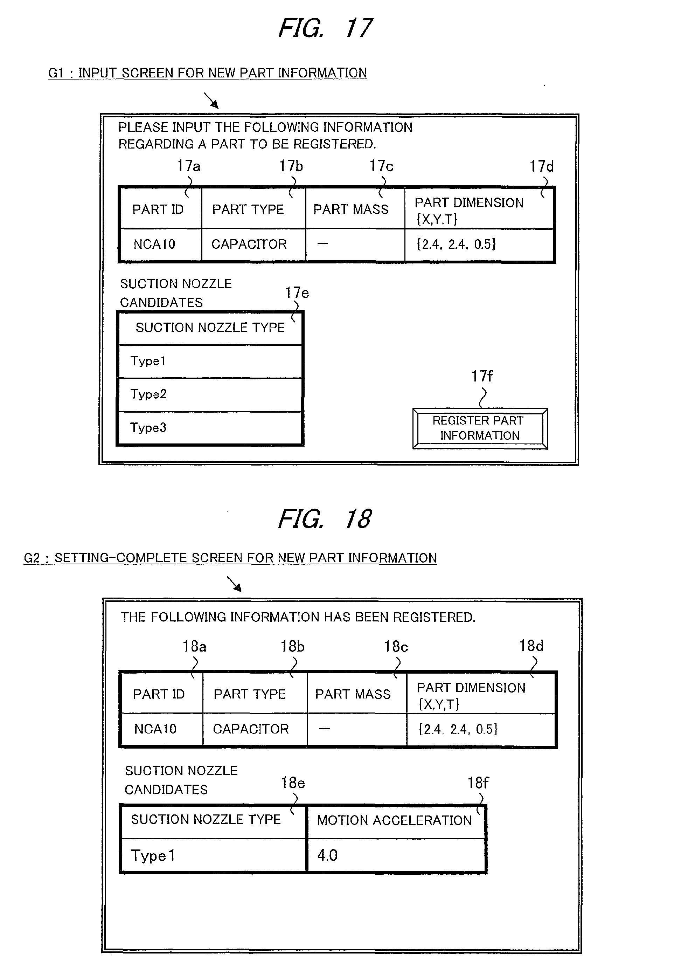

A part-mounting device 100 (a computing device 150) of the embodiment, based on structures of FIGs. 1 to 5, performs a mount-setting calculating processing of FIG. 6 (a processing of determining a part-mounting method (settings for operation control) of the part-mounting device 100) and others, manages data information as illustrated in FIGs. 8 to 16, and inputs and outputs information by a user operating on screens as illustrated in FIGs. 17 to 19.

As one feature, in the mount-setting calculating processing (FIG. 6), information about the mass (m) and dimensions of parts and information about the area (s) of a suction hole of each nozzle and others are used as input information to select an appropriate nozzle type for use in mounting (sucking) a part lowering an anomaly incidence rate, and a computing processing regarding calculation of an appropriate motion acceleration (a) of a corresponding portion such as a head is performed. The computation result information is reflected in information about operation control and settings of the part-mounting device 100 (such as mount information, nozzle information, and part information).

### [Part-Mounting Device]

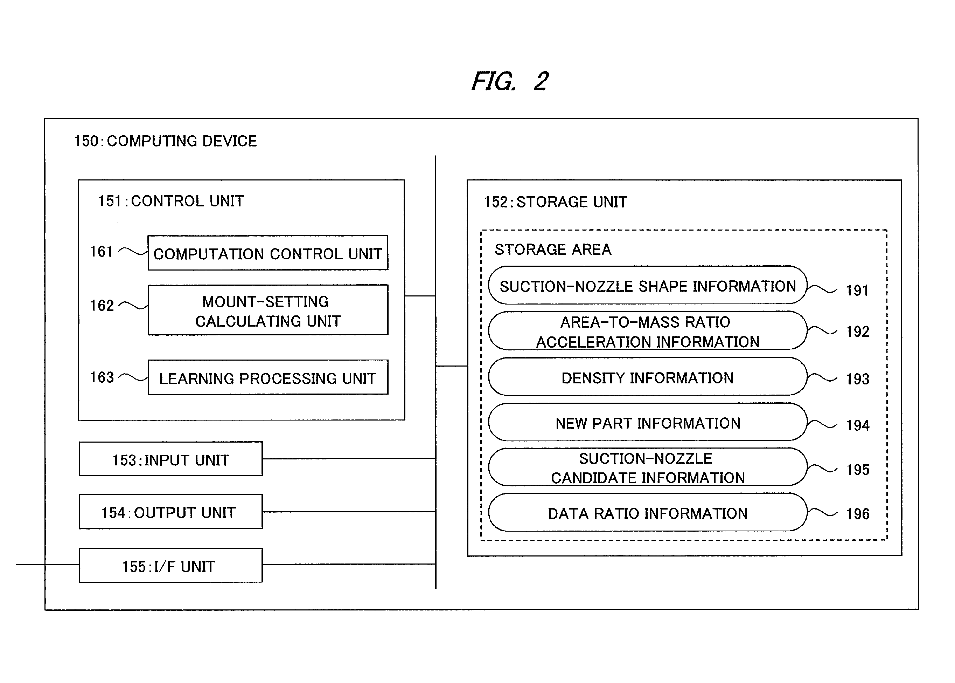

FIG. 1 illustrates a structure of the part-mounting device 100 according to an embodiment of the present invention. FIG. 2 illustrates a structure of the computing device 150 according to an embodiment of the present invention, provided inside the part-mounting device 100. The part-mounting device 100 includes a supply device 110, a placing device 120, an anomaly-detecting device 130, an overall control device 140, a computing device 150, an input device 170, an output device 171, a communication I/F device 172, and others, and these devices are mutually connected via a bus 173. The input device 170 is, for example, a mouse, a keyboard, or the like accepting information input provided by user operation. The output device 171 is, for example, a display, a printer, or the like outputting information to the user. The communication I/F device 172 is an interface for connection to another device or system (connectable to an existing production management system or the like) via the bus 173, an external network, or the like to transmit and receive information. The bus 173 couples respective units (110, 120, 130, 140, 150, 170, 171, and 172). I/F units (112, 125, 132, 146, and others) of the respective devices are interfaces for transmitting and receiving information via the bus 173.

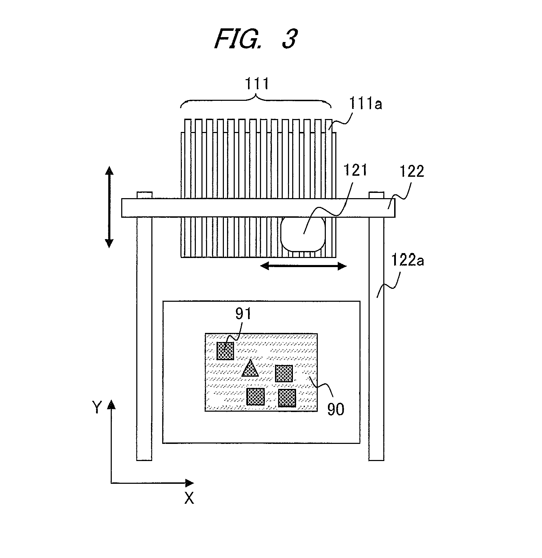

The supply device 110 includes a feeder base 111, the I/F unit 112, and others. In detail, the supply device 110 has a physical structure exemplarily illustrated in FIG. 3 (note that this is merely an example and various structures are applicable).

The placing device 120 includes a head (placing head) 121, a beam 122, a nozzle (a suction nozzle) 123, a driving control unit 124, the I/F unit 125, and others. In detail, the placing device 120 has a physical structure exemplarily illustrated in FIG. 3 (note that this is merely an example and various structures are applicable). The driving control unit 124 controls portions such as the head 121, the beam 122, and the nozzles 123 (such as FIGs. 3 to 5) so that parts are placed in a placing order specified with mount information 181 (FIG. 8), which will be described further below, and at part-mount position coordinates on a substrate according to an instruction from the overall control device 140. Also, when performing control so that a part is sucked by any of the nozzles 123, the driving control unit 124 performs a process of transmitting information (suction information) indicating that the part is sucked to the overall control device 140 via the I/F unit 125.

The anomaly-detecting device 130 includes an anomaly detecting unit 131, the I/F unit 132, and others. The anomaly detecting unit 131 detects an anomaly in a part sucked by the nozzle 123. For example, when instructed by the overall control device 140 to detect an anomaly, the anomaly detecting unit 131 images the part, if present, sucked by the nozzle 123, its position, shape, posture, and others to detect the presence or absence of an anomaly therein by pattern matching or the like. Note that detection can be made by an automatic determining processing on the anomaly detecting unit 131 side. Then, upon detecting the presence of an anomaly in the part, the anomaly detecting unit 131 outputs, to the overall control device 140, information indicating the occurrence of anomalies (anomaly occurrence information). Note that the anomaly detecting means is not restricted to the means such as imaging and pattern matching described above, and various means are applicable.

The overall control device 140 is a main control unit of the part-mounting device 100, and includes a storage unit 141, an overall control unit 145, the I/F unit 146, and others. The storage unit 141 stores, in its storage area, various data information items such as the mount information 181, suction nozzle information 182, and part information 183 (the storage unit 141 has respective information storage units).

The overall control unit 145 controls processings to be performed at the supply device 110, the placing device 120, the anomaly-detecting device 130, the computing device 150, the input device 170, the output device 171, the communication I/F device 172, and others. In particular, the overall control unit 145 uses information (such as the mount information 181) computed (determined) by the computing device 150 to control the operation of the respective portions such as the supply device 110 and the placing device 120 (including the nozzles 123, the head 121, and others) . The control operation by the overall control unit 145 will be described further below.

Note that the structure may be such that the computing device 150 is connected to the outside of the part-mounting device 100. Also, for example, the structure may be such that the computing device 150 and the overall control device 140 are unified.

### [Computing Device]

FIG. 2 shows an example of structure of the computing device 150. The computing device 150 includes a control unit 151, a storage unit 152, an input unit 153, an output unit 154, an I/F unit 155, and others. The computing device 150 can be achieved by a general computer, IC, or others. For example, the control unit 151 can be achieved by hardware such as a CPU or a memory (such as a ROM or a RAM) and its software program processing. For example, with the control unit 151 causing a predetermined program stored in the storage unit 152, outside, or the like to be loaded for execution, each processing function in a computation control unit 161 or the like is achieved. The storage unit 152 can be achieved by a read/write device that reads and writes information from and to any of various memories, an external storage device such as an HDD, or a portable storage medium such as a CD or a DVD or by a device that reads and writes data from an external network. The input unit 153 can be achieved by an input device such as a keyboard or a mouse accepting information input provided by user operation. The output unit 154 can be achieved by an output device such as a display outputting information to the user. The I/F unit 155 can be achieved by an interface for connection to the bus 173 to transmit and receive information via the bus 173.

The control unit 151 includes the computation control unit 161, a mount-setting calculating unit 162, and a learning processing unit 163. The computation control unit 161 controls the entire processing in the computing device 150. The storage unit 152 has stored in its storage area suction-nozzle shape information 191, area-to-mass ratio acceleration information 192, density information 193, new part information 194, suction-nozzle candidate information 195, and data ratio information 196, and others.

As a mount-setting calculating process, the mount-setting calculating unit 162 uses information about a part to be newly registered (a new part), the information (the new part information 194) inputted through the input unit 153 or the I/F unit 155, the suction-nozzle shape information 191, the area-to-mass ratio acceleration information 192, and others to determine any of the nozzles 123 for use in mounting (sucking) the new part, a motion acceleration at the time of moving (controlling) the corresponding head 121, and others through computation. Then, the mount-setting calculating unit 162 (or the control unit 151 or the like) performs a process of setting the determined information such as the new part information 194 (information including a correspondence between parts and the nozzles 123, a motion acceleration of each portion, and others) to the part-mounting device 100 (the overall control device 140). As a setting processing, from the computing device 150, a processing is performed for adding or updating the determined information to the part information 183 of the storage unit 141 of the overall control device 140 or the like. Also, the mount-setting calculating unit 162 (or the control unit 151, the computing device 150, the part-mounting device 100, or the like) performs, as required, a processing of outputting (such as screen display of) the determined information to the user through the output unit 154 and the I/F unit 155 (or the output device 171 or the communication I/F device 172) .

As a learning processing (a learning processing for calculating information about a new part by using information about previously-mounted parts), the learning processing unit 163 performs a processing of using the part information 183 (including information about previous anomalies) in the overall control device 140 to store information in the data ratio information 196 and using the data ratio information 196 to update the area-to-mass ratio acceleration information 192.

### [Supply Device and Placing Device]

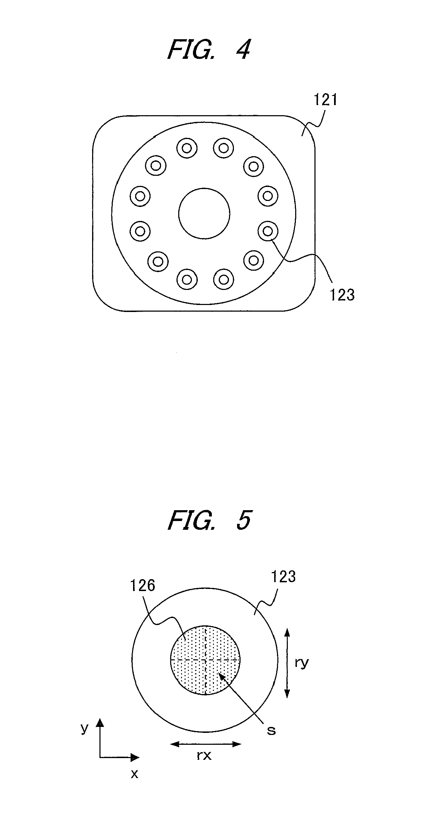

FIG. 3 illustrates a schematic structure (an upper surface) of the feeder base 111, the head 121, the beam 122, a guide 122a, and others associated with the supply device 110 and the placing device 120 of FIG. 1. On the feeder base 111, a plurality of feeders 111a are arranged on-board. On each of the feeders 111a, parts (91) are arranged and held. In response to an instruction from the overall control device 140, when one of the parts (91) held on one of the feeders 111a is sucked by any of the nozzles 123 (FIG. 4), the feeder 111a transfers the remaining parts (91) held thereon to a position where the nozzles 123 can suck these parts.

The operation of the head 121, the beam 122, and others is controlled according to instructions from the overall control device 140. The head 121 is configured so as to be able to be moved along the beam 122 in one coordinate axis direction (in an X direction in FIG. 3). The beam 122 is configured so as to be able to be moved in another coordinate axis direction (in a Y direction in FIG. 3) crossing the coordinate axis direction in which the head 121 moves. In this structure, with the head 121 and the beam 122 being moved in the X direction and the Y direction, a predetermined one of the parts (91) is sucked by a predetermined one of the nozzles 123 (FIG. 4) of the head 121 from a predetermined one of the feeders 111a so that the part (91) can be placed at a predetermined position on a substrate 90.

### [Head and Nozzles]

FIG. 4 shows a lower surface of the head 121. The head 121 has the plurality of nozzles 123 on-board on the lower surface portion. In an example of FIG. 4, the plurality of (for example, twelve) nozzles 123 are arranged in a circle, and the head 121 has a mechanism in which a desired one of the nozzles 123 can be used with rotation control or the like. The position of each nozzle 123 is identified with a number. In this example of structure, the plurality of nozzles 123 are removably on-board on one head 121, and the nozzle 123 at each position is replaceable by human operation. The plurality of nozzles 123 of the head 121 can be varied in type (for example, varied in suction hole area) for each position, for example.

FIG. 5 illustrates a lower surface of any of the nozzles 123. The lower surface of the nozzle 123 in this example has a circular shape, and has a circular suction hole 126 opening. The nozzle 123 has a mechanism in which a part is sucked by decreasing the pressure inside the suction hole 126. Regarding the suction hole 126 of the nozzle 123, its area is taken as "s" and its diameter is taken as "r{rx, ry}". A diameter "rx" represents a length of a portion of the suction hole with the widest width in a direction (an x direction) matching a width (X) of a part, which will be described further below, and a diameter "ry" represents a length of a portion of the suction hole with the widest width in a direction (a y direction) matching a length (Y) of the part, which will be described further below. In this example, s = n × rx ×* rx / 4. Note that the shape of the nozzle 123 and the shape of the suction hole 126 can be any shape other than a circular shape. For example, when the shape of the suction hole 126 is a rectangle and one side of the rectangle is in a direction matching the width (X) of the part and the other side thereof is in a direction matching the length (Y) of the part, the length of one side of the rectangle is represented as rx, the length of the other side thereof is represented as ry, and thus s = rx × ry.

In the present embodiment, from the plurality of nozzles 123 as candidates, any (at least one) of the nozzles 123 suitable for use in part mounting is selected and set. In the present embodiment, it is assumed that the candidates cover all nozzles 123 included in the part-mounting device 100. Also, the candidates may include supplemental nozzles 123 when the nozzles 123 are replaceable. Furthermore, the candidates may be a plurality of nozzles 123 included for each head 121. Still further, the candidates may be not all nozzles 123 but a specific nozzle(s) 123 set in advance.

In addition, various modes of heads 121 and nozzles 123 are applicable. For example, a plurality of heads and nozzles are on-board in one unit in one structure, and a nozzle is fixedly on-board on a head in another structure (the structure in which the head and the nozzles are integrally provided). According to the correspondence between the head and the nozzle, a selection of a nozzle is equivalent to a selection of a corresponding head or the like, and a motion acceleration to be calculated or the like is a motion acceleration or the like of a portion such as the corresponding head.

### [Anomaly]

Here, based on the structure described above, a relation between anomalies such as a drop of the part (91) from the nozzle 123 and elements such as parts, the nozzles 123, the beam 122, and the head 121 will be described.

When a force required for suction of a part (hereinafter, referred to as a "necessary suction force", such as the inertial force or air resistance of the part described in the background art section) is larger than a suction force of the nozzle 123, an anomaly such as a drop of the part tends to occur.

The suction force of the nozzle 123 is generated by decompressing the inside of the suction hole 126 of the nozzle 123. If the decompression amount is constant, the suction force is increased in proportion to the area (s) of the suction hole 126.

On the other hand, the necessary suction force is in proportion to a product (for each element) of the mass (m) of the part, an inverse of a coefficient of friction of the part, and a motion acceleration of the nozzle 123 or a portion such as the head 121 or the beam 122 where the nozzle 123 is mounted. When the nozzle 123 sucking the part is moved with a further larger motion acceleration, an inertial force on the part is increased, thereby increasing the necessary suction force. Also, when the portion such as the head 121 is moved with a further larger motion acceleration, the motion acceleration is increased in order to achieve a large motion speed, thereby increasing the necessary suction force.

Consider a condition for less occurrence of anomalies such as a drop of the part, that is, a condition for the suction force in proportion to the area (s) of the suction hole 126 to be larger than the necessary suction force. From this condition, Expression (1) : s / m × β > a is obtained. In Expression (1), "s" represents an area s of the suction hole 126 of the nozzle 123 described above, "m" represents a mass of the part to be mounted (sucked), "a" represents a motion acceleration of the portion such as the head 121 associated with the nozzle 123, and "β" represents a value determined by the coefficient of friction, the amount of decompression, or the like.

Therefore, in the present embodiment, by using a value obtained by dividing the area s by the mass m (an area-to-mass ratio: s/m), the motion acceleration a of the portion such as the head 121 or the like is determined (a < (s/m) × β). Also, the surface material of the part varies according to the part type, and the value of β determined by the coefficient of friction or the like varies. Therefore, in the present embodiment, the motion acceleration "a" or the like is determined for each part type. Note that, also regarding the motion speed "vx", for example, a = vx / t (t represents a time from the time when the head 121 stops to the time when a predetermined motion speed vx is achieved) is substituted into Expression (1), the relation can be expressed as v < (s/m) × β × t. Thus, as with the motion acceleration a, it is possible to determine a value by using a value obtained by dividing the area s by the mass m.

### [Process Outline]

FIG. 6 illustrates a processing to be preformed mainly by the mount-setting calculating unit 162 of the computing device 150 (S11 and the like each represents a processing step). As a processing outline of FIG. 6, data information for computation (new part information) is inputted at S11 and, in response, information about the mass (m) of the part is obtained particularly at S12 and S13. At S14 and S15, it is determined whether the nozzles 123 of the plurality of types as candidates for use in suction of the part can be used. At S16, the motion acceleration (a) of the portion (the head 121) corresponding to the nozzle 123 is calculated and, based on that, the nozzle 123 for use in mounting the part at S17 is selected and is set to the part-mounting device 100. At S18, result information is outputted to the user.

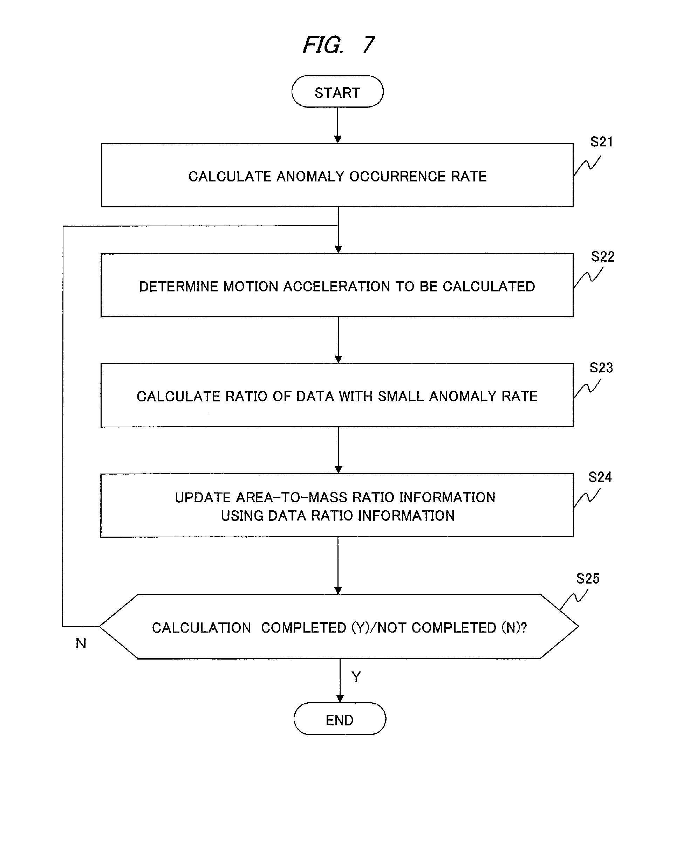

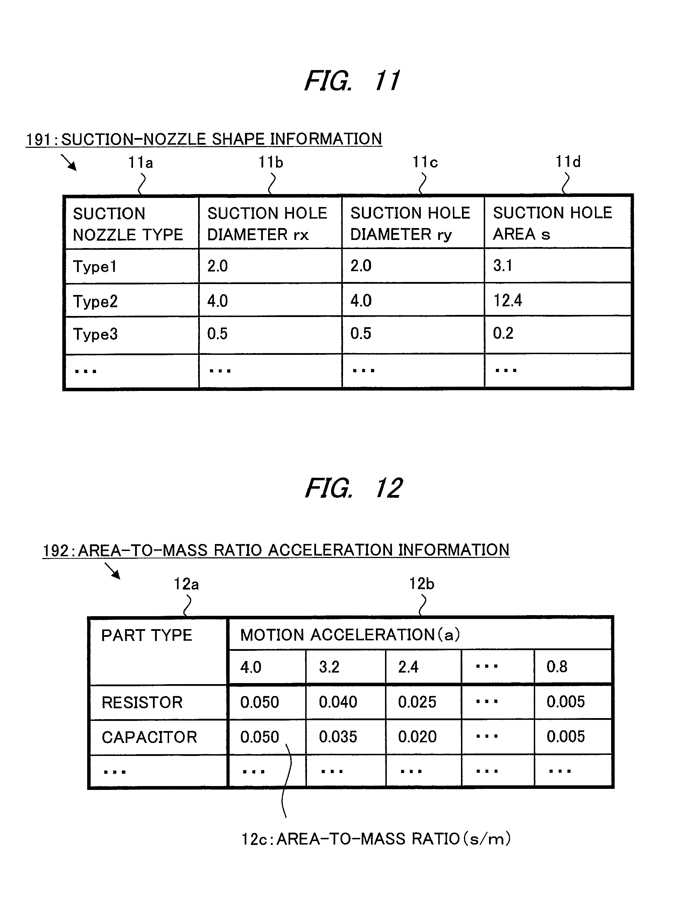

Also, FIG. 7 shows a process to be performed by the learning processing unit 163 (a process of updating the area-to-mass ratio acceleration information 192 (FIG. 12)).

In the following, various pieces of data information (181 to 183 and 191 to 196) will be described first, and then processing details of FIGs. 6 and 7 will be described.

### [Mount Information]

The mount information 181 of FIG. 1 includes information about the placing sequence and the suction sequence of the parts (91) onto the substrate (90) and information for specifying a position where a part is to be placed on the substrate, the nozzle 123 (position) for sucking a part, the feeder 111a (position) when the part is sucked by the nozzle 123, the name of a part to be sucked, and others. The mount information 181 is one piece of information for controlling the movement (a movement associated with part mounting) of each portion (including the feeders 111a, the head 121, the beam 122, and the nozzles 123) of the part-mounting device 100.

FIG. 8 illustrates an example of a table for the mount information 181. In the present embodiment, the table for the mount information 181 is stored and managed in the storage unit 141 of the overall control device 140 (the same goes for the other information). The table is composed of records having fields such as sequence (8a), part placing position coordinates (8b), suction nozzle number (8c), feeder number (8d), and part ID (8e).

In the sequence 8a, information for specifying the placing sequence of the part and the suction sequence of the part is stored. While the present embodiment is configured so that the placing sequence of the part and the suction sequence thereof are equal to each other, these sequences may be different. In the part placing position coordinates 8b, coordinates {X, Y} on the substrate are stored as information for specifying a position where the part is to be placed on the substrate.

In the suction nozzle number 8c, information for specifying the nozzle 123 that sucks the part is stored. In the present embodiment, as information for specifying the position of the nozzle 123 on the head 121 associated with the nozzle 123, a suction nozzle number (for example, 1 to 12) allocated so as to uniquely identify the position where the nozzle 123 is to be placed is used.

In the feeder number 8d, information for specifying a feeder to hold the part placed at the coordinates indicated by 8b in the sequence 8a is stored. In the present embodiment, a feeder number uniquely identifying the position where the feeder 111a is to be placed in the feeder base 111 (FIG. 3) is stored.

In the part ID 8e, as information for specifying a part to be placed at the position of the feeder 111a indicated by the feeder number 8d in the sequence 8a, a part ID (such as an identification code or a name) uniquely identifying each of the plurality of parts is stored. Note that, in the present embodiment, a "part" and a "part type" are different.

### [Suction Nozzle Information]

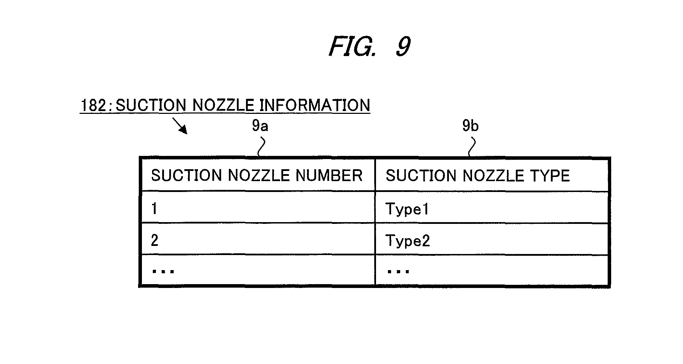

FIG. 9 illustrates an example of a table for the suction nozzle information 182. The table has fields such as suction nozzle number (9a) and suction nozzle type (9b). As with the suction nozzle number (8c), the suction nozzle number 9a indicates information for specifying the nozzle 123 (a number indicating the position on the head 121). The suction nozzle type 9b stores therein information for specifying the type of the nozzle 123 to be placed at the position indicated by the suction nozzle number 9a. In the present embodiment, the name of the type of the nozzle 123 (for example, "Type 1") is stored.

### [Part Information]

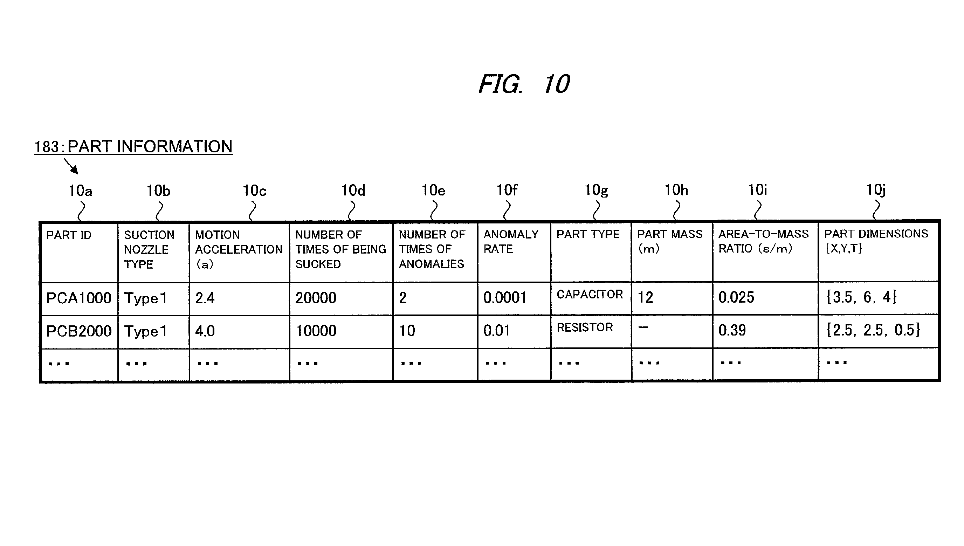

FIG. 10 illustrates an example of a table for the part information 183. The table has fields such as part ID (10a), suction nozzle type (10b), motion acceleration (10c), the number of times of being sucked (10d), the number of times of anomalies (10e), anomaly rate (10f), part type (10g), part mass (10h), area-to-mass ratio (10i), and part dimensions (10j). The part information 183 includes various information about a part to be placed at the position indicated by the feeder number (8d).

As with the part ID 8e, the part ID 10a represents information for specifying the part. The suction nozzle type 10b stores therein information for specifying the type of the nozzle 123 sucking the part indicated by the part ID 10a (the information being similar to the suction nozzle type 9b). The motion acceleration 10c stores therein information about a motion acceleration (a) at the time of moving the part (in the present embodiment, the head 121) corresponding to the nozzle 123 of the type when the part indicated by the part ID 10a is sucked by the nozzle 123 of the type. Note that, according to the correspondence, the part is the beam 122 or the like and the motion acceleration (a) is a motion speed or the like.

Note that, while the nozzle type (10b) is associated with the part ID (10a) by selection in the present embodiment, association can be made by using the part type, the nozzle ID, or the like, as a modification example.

The number of times of being sucked 10d stores therein information about the number of times the part indicated by the part ID 10a has been sucked by the nozzle 123 of the type. Note that the number of times of being sucked 10d can be obtained also from production history information or the like. The number of times of anomalies 10e represents information about the number of times (the number of times of occurrence of anomalies) the part indicated by the part ID 10a has been determined by the anomaly-detecting device 130 as having an anomaly (a predetermined anomaly such as a drop of the part). The anomaly rate (anomaly incidence rate) 10f represents a ratio of occurrence of anomalies, and stores therein a value obtained by dividing a value stored in the number of times of anomalies 10e by a value stored in the number of times of being sucked 10d (10e/10d).

The part type 10g stores therein information specifying the type of the part indicated by the part ID 10a. For example, the information indicates a resistor, a capacitor, or the like. The part mass 10h stores therein information of the mass (m) of the part indicated by the part ID 10a. The mass (m) may be in any form, such as a measured value or a catalog value. If the mass (m) cannot be specified because it cannot be measured, no catalog value has been inputted, or due to other reasons, the part mass 10h stores therein information indicating that the mass (m) cannot be specified (for example, the symbol "-"). For example, as for a record having "PCB2000" stored in the part ID 10a, an m value is unknown.

Regarding the part indicated by the part ID 10a and the type of the nozzle 123 (for use in sucking the part) indicated by the suction nozzle type 10b, the area-to-mass ratio (s/m) 10i stores therein information about a ratio (an area-to-mass ratio) of the area (s) of the suction hole 126 of the nozzle 123 of the type indicated by the suction nozzle type 10b with respect to the mass (m) 10h.

The part dimensions 10j store therein information about the dimensions of the part indicated by the part ID 10a. In the present embodiment, information {X, Y, T} indicating the width (X), length (Y), and thickness (T) of the part is stored. The width (X) represents a part dimension in a direction (X in FIG. 3) matching the direction of the diameter rx (x in FIG. 5) of a surface of the part in contact with the nozzle 123, the length (Y) represents a part dimension in a direction (Y in FIG. 3) matching the direction of the diameter ry (y in FIG. 5), and the thickness (T) represents a part dimension in a direction orthogonal to the contact surface.

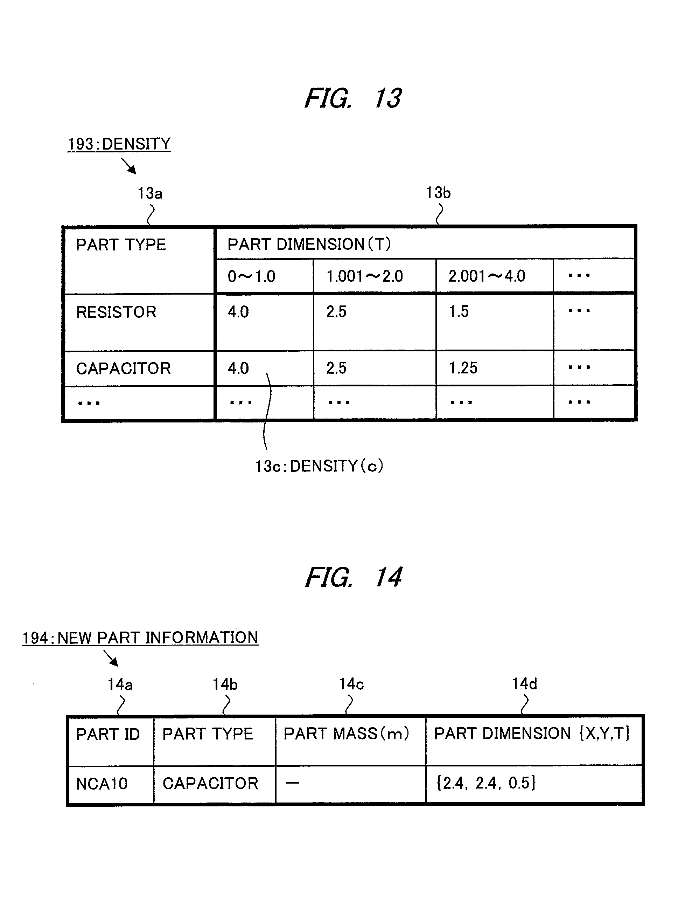

Note that, if the part mass (m) 10h cannot be specified, the area-to-mass ratio 10i stores therein a value obtained by dividing a value which is calculated based on the part dimensions 10j (such as a volume (v) obtained from the dimensions) and information about a density (c) in a table (FIG. 13) for density information 193, which will be described further below, by the area (s) of the suction hole 126 of the nozzle 123 of the type indicated by the suction nozzle type 10b.

In the state after the mount settings are determined by the computing device 150, the mount information 181, the suction nozzle information 182, and the part information 183 serving as setting information for a part-mounting method (operation control) include information about a correspondence among the information about the target part (8e, 10a, and 10g), the information about the nozzle 123 to be used for the part and its characteristics (8c, 9a, and 9b), and the information (10c) about the motion acceleration (a).

### [Example of Control by Overall Control Unit]

An example of control by the overall control unit 145 using the information (181 to 183) is as follows. The overall control unit 145 outputs a necessary instruction to the supply device 110 and the placing device 120 so that the part to be arranged at the position indicated by the feeder number (8d) in the sequence (8a) in the table (FIG. 8) for the mount information 181 is sucked by the nozzle 123 indicated by the suction nozzle number (8c) and the part is moved to be placed at the coordinates (8b) with the motion acceleration (10c) or the like in the table (FIG. 10) for the part information 183.

When outputting an instruction for sucking the part, the overall control unit 145 reads the value of the suction nozzle number (8c) and the value (which is assumed to be d01 by way of example for description) of the part ID (8e); specifies a row of the suction nozzle number (9a) in the table (FIG. 9) for the suction nozzle information 182, the row storing therein the same value as the suction nozzle number; and reads the value (which is assumed to be d02) of the suction nozzle type (9b) in the row. Furthermore, in the table (FIG. 10) for the part information 183, the overall control unit 145 specifies a row storing, in the part ID (10a), the same value as d01 mentioned above and storing, in the suction nozzle type (10b), the same value as d02 mentioned above, and adds 1 to the value stored in the number of times of being sucked (10d) in the row.

Also, after outputting an instruction for sucking the part to be arranged at the position indicated by the feeder number (8d), the overall control unit 145 outputs a necessary instruction to the anomaly-detecting device 130 so that an anomaly of the sucked part is detected at a necessary timing.

When the anomaly-detecting device 130 detects an anomaly, the overall control unit 145 reads the value of the suction nozzle number (8c) and the value (which is assumed to be d03) of the part ID (8e) ; specifies a row of the suction nozzle number (9a) storing therein the same value as the suction nozzle number; and reads the value (which is assumed to be d04) stored in the suction nozzle type (9b) in the row. Furthermore, the overall control unit 145 specifies a row storing, in the part ID (10a), the same value as d03 mentioned above and storing, in the suction nozzle type (10b), the same value as d04 mentioned above, and adds 1 to the value stored in the number of times of anomalies (10e) in the row.

After incrementing the value of the number of times of anomalies (10e), the overall control unit 145 again performs a sucking operation which is the previous one having the occurrence of the anomaly.

Each of the pieces of information (191 to 196) stored in the computing device 150 will be described below. These information pieces are managed as information necessary for the processings of the computing device 150. Note that, as required, these pieces of information may be unified with each of the pieces of information (181 to 183) in the overall control device 140, or may be separated from each other.

### [Suction Nozzle Shape Information]

FIG. 11 illustrates an example of a table for the suction nozzle shape information 191. In the present embodiment, the table for the suction nozzle shape information 191 is stored and managed in the storage unit 152 of the computing device 150 (the same goes for the other information). The table has fields such as suction nozzle type (11a), suction hole diameter rx (11b), suction hole diameter ry (11c), and suction hole area s (11d).

In each row of the suction nozzle type 11a, information for specifying the type of the nozzle 123 is stored. In each row of the suction hole diameter rx denoted as 11b and the suction hole diameter ry denoted as 11c, the breadth (rx in FIG. 5) and the length (ry in FIG. 5) of the suction hole 126 of the nozzle 123 of the type indicated by the suction nozzle type 11a are stored. When the part is sucked by the nozzle 123, suction operation control is performed so that the direction of the diameter rx corresponds to the direction of the width (X) of the part and the direction of the diameter ry corresponds to the direction of the length (Y) of the part. In each row of the suction hole area s 11d, information about the area (s in FIG. 5) of the suction hole 126 of the nozzle 123 of the type indicated by the suction nozzle type 11a is stored.

### [Area-to-Mass Ratio Acceleration Information]

FIG. 12 illustrates an example of a table for the area-to-mass ratio acceleration information 192. The table has fields and cells such as part type (12a), motion acceleration (12b), and area-to-mass ratio (12c). In each row of the part type 12a, information for specifying the type of the part (the information being similar to the part type 10g) is stored. In each column of the motion acceleration (a) 12b, information about the motion acceleration at the time of moving the portion (the head 121) (the information being similar to the motion acceleration 10c) is stored. In each cell of the area-to-mass ratio (s/m) 12c, a value (s/m) obtained by dividing the area s of the suction hole 126 of the nozzle 123 by the mass m of the part according to the corresponding part type 12a and the motion acceleration 12b is stored.

When the area-to-mass ratio (s/m) calculated for the part to be mounted and the nozzle 123 is larger than the value stored in the area-to-mass ratio (12c) in the table, this indicates that the part can be sucked by the nozzle 123 without anomalies (with a sufficient low possibility of occurrence of anomalies). For example, when a part with its part type being "resistor" and its mass (m) being 5 is sucked by the nozzle 123 of a type ("Type 3") with its suction hole area (s) being 0.2, the area-to-mass ratio (s/m) is 0.2 / 5 = 0.04 and, among the cells of the area-to-mass ratio (12c) in the row with the part type (12a) being "resistor" in the table, a search is made for a cell having stored therein a value being equal to or smaller than 0.04. Then, a value (for example, 2.4) stored in the motion acceleration (12b) positioned in the column of a cell (for example, a cell having 0.025) is taken as a motion acceleration (a) with which mounting is possible without anomalies.

### [Density Information]

FIG. 13 illustrates an example of a table for the density information 193. The table has fields and cells such as part type (13a), part dimension (13b), and density (13c). In each row of the part type 13a, information (the information being similar to the part type 10g) for specifying the type of the part is stored. In each column of the part dimension 13b, information indicating a range of the magnitude of a dimension of the part is stored. In the present embodiment, information for specifying a range of the thickness (T) of the part is stored. Note that not only the thickness (T) but also other characteristic values such as the width, length, area, and volume of the part may be used. In each cell of the density 13c, information for specifying the density (or specific gravity or the like) of the part is stored. Because the material of the part varies according to the type of the part and the ratio of materials forming the part (for example, a ratio between a silicon portion inside an IC and a plastic portion of an exterior portion) varies according to the size of the part, the density of the part varies according to the type and size of the part. Therefore, in the present embodiment, the density (13c) is set for each part type (13a) and the part size (13b).

### [New Part Information]

FIG. 14 shows an example of a table for the new part information 194. The table has fields such as part ID (14a), part type (14b), part mass (14c), and part dimensions (14d). The part ID 14a stores therein information for specifying the part (the information being similar to the part ID 10a). The part type 14b stores therein information for specifying the type of the part indicated by the part ID (14a) (the information being similar to the part type 10g). The part mass 14c stores therein information about the mass (m) of the part indicated by the part ID (14a) (the information being similar to the part mass 10h) (if the mass (m) cannot be specified, "-" is stored). The part dimensions 14d store therein information about dimensions {X, Y, T} of the part indicated by the part ID (14a) (the information being similar to the part dimensions 10j).

The new part information 194 temporarily stores therein information about a part to be newly registered (a part for which a computation is to be performed) regarding a processing by the mount-setting calculating unit 162. The new part information 194 is added to the mount information 181 in the overall control device 140 according to the determination of the settings.

### [Suction Nozzle Candidate Information]

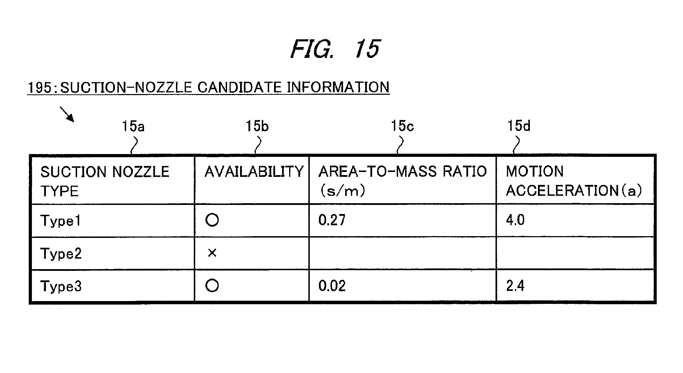

FIG. 15 shows an example of a table for the suction-nozzle candidate information 195. The table has fields such as: (15a) suction nozzle type; (15b) availability; (15c) area-to-mass ratio; and (15d) motion acceleration. The suction-nozzle candidate information 195 temporarily stores therein information required for selecting any of the nozzles 123 and calculating the motion acceleration (a) of the portion (the head 121) in the process by the mount-setting calculating unit 162. In the suction-nozzle candidate information 195, information about candidates for the nozzle 123 for use in sucking the part (new part) indicated in the table (FIG. 14) for the new part information 194 is managed.

The suction nozzle type 15a stores therein information for specifying the type of the nozzle 123 as a candidate (the information being similar to the suction nozzle types 9b, 11a, and others) . The availability 15b stores therein information indicating whether the candidate for the nozzle 123 of the type indicated by the suction nozzle type 15a can be (suitably) used for sucking the new part. In the present embodiment, binary information is stored. When the candidate is determined as being available, "○" is stored. When the candidate is determined as not being available, "x" is stored.

The area-to-mass ratio (s/m) 15c stores therein a value obtained by dividing the value (11d) of the area (s) of the nozzle 123 of the type indicated by the suction nozzle type (15a) by the mass (14c) of the new part or a value (a mass equivalent value) calculated from the dimensions (14d) and the density (13c) thereof. The motion acceleration (a) 15d stores therein, as information about the nozzle 123 of the candidate for use in sucking the new part, information about the motion acceleration (a) of the portion (the head 121) when the nozzle 123 of the type indicated by the suction nozzle type 15a is used for mounting the part.

### [Data Ratio Information]

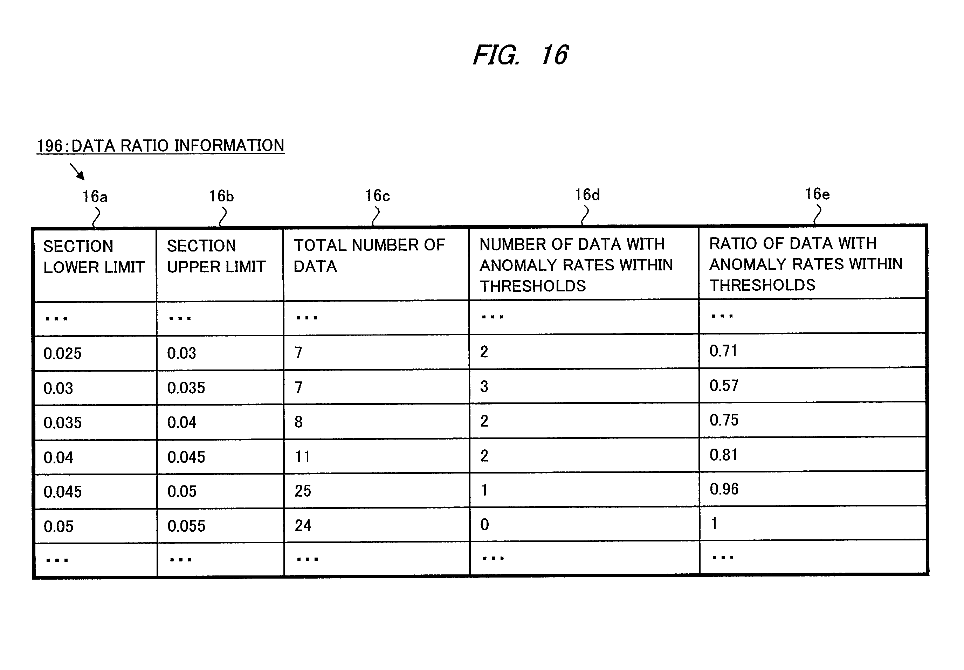

FIG. 16 illustrates an example of a table for the data ratio information 196. The table has fields such as: (16a) section lower limit; (16b) section upper limit; (16c) total number of data; (16d) total number of data with anomaly rates within thresholds; and (16e) ratio of data with anomaly rates within thresholds. The data ratio information 196 temporarily stores therein data for use in a process at the learning processing unit 163.

The section lower limit 16a stores therein a value set in advance as information for specifying a lower limit of a calculation section in a processing by the learning processing unit 163 for calculating the total number of data 16c and the number of data with anomaly rates within thresholds 16d, which will be described further below. Similarly, the section upper limit 16b stores therein a value set in advance for specifying an upper limit of the calculation section.

The total number of data 16c stores therein information for specifying the number of data in a section from the section lower limit 16a to the section upper limit 16b calculated in the processing by the learning processing unit 163, which will be described further below. In the number of data with anomaly rates within thresholds 16d, among data in the section from the section lower limit 16a to the section upper limit 16b to be calculated is calculated in the processing by the learning processing unit 163, which will be described further below, information for specifying the number of data with small anomaly rates is stored. The ratio of data with anomaly rates within thresholds 16e stores therein a value calculated in the process of the learning processing unit 163, which will be described further below, the value (16d/16c) being obtained by dividing the number of data with anomaly rates within thresholds (16d) by the total number of data (16c).

### [Mount-Setting Calculating Process]

Next, based on the flow of FIG. 6, also with reference to examples of screens of FIGs. 17 and 18, a processing will be described in detail as a processing by the computing device 150 (the mount-setting calculating unit 162). In this process, when information about a part to be newly registered (a new part) is inputted by a user or the like, the type of the nozzle 123 for use in mounting the new part is selected, the motion acceleration (a) of the corresponding portion (the head 121) and others are determined by computation, and the determined information is stored in (added to) the part information 183 in the overall control device 140 for setting.

First, the computing device 150 (the computation control unit 161) accepts an input of information about the new part and others via the input unit 153 or the I/F unit 155 from the user through a screen G1 of FIG. 17 (stores input information in the storage unit 152). When the information is inputted, the computing device 150 (the computation control unit 161) causes the mount-setting calculating unit 162 to perform the processing of FIG. 6.

On the screen G1 (an input screen for the new part information) of FIG. 17, a box for inputting information about the part to be newly registered (new part information) is displayed on an upper side, and a box for inputting information about nozzle candidates is correspondingly displayed on a lower side. As the new part information (input information), part ID 17a, part type 17b, part mass (m) 17c, and part dimensions 17d are provided, and suction nozzle type (information for specifying the type of the nozzles 123 as candidates) 17e is provided on the lower side. The information on the upper side is associated with the new part information 194 of FIG. 14, and the information on the lower side is associated with the suction nozzle candidate information 195 of FIG. 15. When an icon 17f indicating "register part information" is clicked by user operation, the new part information (input information) is transmitted (inputted) to the computing device 150 for registration.

(S11) At S11, the mount-setting calculating unit 162 reads and writes the input information (new part information). The mount-setting calculating unit 162 stores the input information in the new part information 194, the suction-nozzle candidate information 195, and others of the storage unit 152. For example, the input information (17a to 17d) is stored in the corresponding fields 14a to 14d, respectively, in the table (FIG. 14) for the new part information 194. Also, the input information about the suction nozzle type (17e) is stored in the field of the suction nozzle type (15a) in the table (FIG. 15) for the suction-nozzle candidate information 195.

(S12) Next, at S12, the mount-setting calculating unit 162 checks whether the part mass information has been inputted to determine the next process. At S12, the mount-setting calculating unit 162 checks whether the stored information (input information) of the part mass (14c) in the table (FIG. 14) for the new part information 194. If the part mass (m) has not been inputted ("-"), a process at S13 is performed. If the part mass (m) has been inputted (if a positive real number has been inputted), the procedure returns to S14.

(S13) At S13, the mount-setting calculating unit 162 uses the information stored in the new part information 194 (information about the part shape (dimensions)) and the information (information about density) stored in the density information 193 to perform a processing of calculating a part mass (m). For example, the mount-setting calculating unit 162 reads the information (which is assumed to be d131) stored in the part type (14b) and the information (which is assumed to be {X, Y, T} = {d132, d133, d134}) stored in the part dimensions (14d), specifies a row having the same value of the part type (13a) in the table (FIG. 13) for the density information 193 as the stored information d131 and a column having the thickness d134 within the range of the dimension (T) stored in the part dimension (13b), and reads stored information (which is assumed to be d135) of the density (13c) of the cells at the position of the row and column.

Furthermore, the mount-setting calculating unit 162 calculates a value (d132×d133×d134×d135) of the product of the dimensions {d132, d133, d134} and the density (d135). This value is a value obtained by multiplying the volume (v: X×Y×T) of the part by the density (c), that is, an equivalent value (a rough order of magnitude) of the part mass (m).

(S14) Next, at S14, the mount-setting calculating unit 162 performs a first determination process as to whether the nozzle candidate is available. That is, by comparing the magnitude of the dimensions of the part and the magnitude of the diameter r of the suction hole 126 of the nozzle 123, a determination is made as to whether the nozzle 123 (candidate) of the type for the part is available. The mount-setting calculating unit 162 uses the information stored in the suction-nozzle shape information 191, the new part information 194, and the suction-nozzle candidate information 195 to determine whether the candidate nozzle 123 indicated by the suction-nozzle candidate information 195 is available, and then stores, in the suction-nozzle candidate information 195, information as to whether the nozzle is available, that is, the determination result.

In the determination, an available nozzle means a nozzle with a sufficiently low possibility of occurrence of anomalies, and a non-available nozzle means a nozzle with a high possibility of occurrence of anomalies.

For example, the mount-setting calculating unit 162 performs calculation for each of the rows from the first row to the last row in the table (FIG. 15) for the suction-nozzle candidate information 195 (for the purpose of description, a row for calculation is hereinafter referred to as an n-th row).

The mount-setting calculating unit 162 reads information stored in the n-th row of the suction-nozzle type (15a) (the information is assumed to be d141), specifies a row in which the same value as d141 described above is stored in the suction nozzle type (11a) in the table (FIG. 11) for the suction-nozzle shape information 191, and then reads information stored in the suction hole diameter rx (11b) (the information is assumed to be d142) and information stored in the suction hole diameter ry (11c) (the information is assumed to be d143) in the row.

Furthermore, the mount-setting calculating unit 162 reads information stored in the part dimensions (14d) in the table (FIG. 14) for the new part information 194 (the information is assumed to be {X, Y, T} = {d144, d145, d146}). When d144 is larger than d142 and d145 is larger than d143, information "○" indicating that the nozzle candidate is available is stored in the n-th row of the availability (15b). When the information "○" is not stored, information "x" indicating that the nozzle candidate is not available is stored in the n-th row thereof.

If the diameter of the suction hole 126 is larger than the dimensions of the part, when the inside of the nozzle 123 is decompressed, air is mixed to increase the pressure, thereby significantly decreasing the suction force and causing the part to easily drop. For this reason, at S14, whether the type of the nozzle 123 is available is determined and decided so that the diameter of the suction hole 126 is not larger than the dimensions of the part.

(S15) Next, at S15, the mount-setting calculating unit 162 performs a second determination processing as to whether the nozzle candidate is available. That is, by comparing the mass (m) of the part and the area (s) of the suction hole 126 of the nozzle 123, a determination is made as to whether the nozzle 123 (candidate) of the type for the part is available. The mount-setting calculating unit 162 uses information such as the information stored in the suction-nozzle shape information 191, the information stored in the new part information 194, the information about the mass (m) by the input or the value calculated at S13, and the information stored in the area-to-mass ratio acceleration information 192 to determine whether the nozzle candidate indicated by the information stored in the suction-nozzle candidate information 195 is available.

In the present embodiment, for the determination at S15, the value of the suction hole area s (precisely, a ratio between the area s and the mass m (s/m) required for performing a mounting (sucking) operation without causing anomalies is set in advance, and availability is determined by using this setting value for determination (which is assumed to be p). Note that the setting value (p) is updated in a processing of FIG. 7, which will be described further below.

For example, the mount-setting calculating unit 162 performs the following calculation for a row with its availability (15b) being indicated by "○" among the rows from the first row to the last row of the suction nozzle type (15a) (a row for calculation is hereinafter referred to as an n-th row).

The mount-setting calculating unit 162 reads information stored in the n-th row of the suction nozzle type (15a) (the information is assumed to be d151), specifies a row in which the same value as d151 mentioned above is stored in the suction nozzle type (11a) of FIG. 11, and then reads information stored in the suction hole area s (11d) (the information is referred to as d152) in the row.

Furthermore, the mount-setting calculating unit 162 reads information (which is assumed to be d153) stored in the part mass (14c) in FIG. 14. When d153 indicates that mass information is present (when "-" is not present), the mount-setting calculating unit 162 calculates a value by dividing d152 by d153 (d152/d153). When d153 indicates that mass information is not present (when "-" is present), the mount-setting calculating unit 162 calculates a value by dividing d152 by v×c mentioned above. Then, the mount-setting calculating unit 162 stores the calculated value in the n-th row of the area-to-mass ratio (15c) of FIG. 15. The value calculated herein is assumed to be d154.

Still further, for the part type (12a) in the table (FIG. 12) for the area-to-mass ratio acceleration information 192, the mount-setting calculating unit 162 specifies a row in which the same information as d131 is stored. Also, for the motion acceleration (12b), the mount-setting calculating unit 162 specifies a column with its stored value being minimum. Then, the mount-setting calculating unit 162 reads a value (which is assumed to be d155) stored in the area-to-mass ratio (12c) of the cell at the position corresponding to the row and the column.

Still further, when d155 is larger than d154, the mount-setting calculating unit 162 stores information "×" indicating that the nozzle 123 of the type is not available in the n-th row of the availability (15b) in FIG. 15. Here, the nozzle type (candidate) for which "x" is stored indicates that it has been determined that there is a high possibility that an anomaly occurs in the part indicated by the new part information 194 even with a minimum motion acceleration (a).

(S16) Next, at S16, the mount-setting calculating unit 162 uses the information about the part mass (m) and the information about the area (s) of the suction hole 126 of the nozzle 123 to perform a process of calculating a motion acceleration (a) of a portion associated with the nozzle 123. In the present embodiment, a value of the suction hole area s required for performing a mounting operation without causing anomalies (precisely, the ratio between the area s and the mass m (s/m)) is set in advance for each motion acceleration (a), and the setting value (which is assumed to be q) is used to calculate the motion acceleration (a). Note that the setting value (q) is updated in the process of FIG. 7.

At S16, the mount-setting calculating unit 162 uses the suction-nozzle shape information 191 and the area-to-mass ratio acceleration information 192 to calculate the motion acceleration (a) of the head 121 when the nozzle candidate indicated by the suction-nozzle candidate information 195 is (assumed to be) used for a mounting operation. For example, among the rows from the first row to the last row in the table (FIG. 15) for the suction-nozzle candidate information 195, the mount-setting calculating unit 162 performs the following calculation for the rows with their availability (15b) being "○" (a row for calculation is hereinafter referred to as an n-th row).

The mount-setting calculating unit 162 then reads information stored in the n-th row of the area-to-mass ratio (15c) (the information is assumed to be d161).

Furthermore, for the part type (12a) in the table (FIG. 12) for the area-to-mass ratio acceleration information 192, the mount-setting calculating unit 162 specifies a row in which the same information as d131 is stored and compares, sequentially from a column in which a large value is stored in the motion acceleration (12b), the magnitude of d161 and the magnitude of the value stored in the area-to-mass ratio (12c) of a cell at a position corresponding to the row and the column. When d161 is larger than the value stored in the area-to-mass ratio (12c), the value stored in the motion acceleration (12b) in the column is stored in the n-th row of the motion acceleration (15d) in FIG. 15, and then the processing at S16 ends.

(S17) Next, at S17, the mount-setting calculating unit 162 uses the determination results (availability) at S14 and S15, the information about the motion acceleration (a) calculated at S16, and others to select the type of the nozzle 123 for use in mounting (sucking) the part. Also, according to the selection, the mount-setting calculating unit 162 uses the information stored in the new part information 194 and the suction-nozzle candidate information 195 to update the part information 183 in the overall control device 140.

For example, the mount-setting calculating unit 162 adds one row to the last row in the table (FIG. 10) for the part information 183, stores the information stored in the part ID (14a) in FIG. 14 in the last row of the part ID (10a) in FIG. 10 and, similarly, stores the information stored in the part type (14b), the part mass (14c), and the part dimensions (14d) in the last row of the corresponding part type (10g), the part mass (10h), and the part dimensions (10j).

Furthermore, among the rows from the first row to the last row in the table (FIG. 15) for the suction-nozzle candidate information 195, in a row with its availability (15b) being "○" and a value stored in the motion acceleration (15d) being largest, the mount-setting calculating unit 162 reads values stored in the motion acceleration (15d) and the suction nozzle type (15a), and stores the stored values in the last rows of the corresponding suction nozzle type (10b) and motion acceleration (10c) of FIG. 10.

(S18) Next, at S18, the mount-setting calculating unit 162 outputs the information stored in the part information 183, which indicates the result at S17 (including the information about the selected nozzle type and the motion acceleration (a)), to the user via the output unit 154 or the I/F unit 155. For example, the information is outputted to a screen G2 in FIG. 18.

FIG. 18 illustrates the screen G2 (a setting-complete screen for the new part information). The mount-setting calculating unit 162 causes the information stored in the last row of the part ID (10a) of the part information 183 of FIG. 10 to be displayed in part ID 18a on the screen G2 and, similarly, causes the information stored in the last rows of the part type (10g), the part mass (10h), and the part dimensions (10j) to be displayed in corresponding part type 18b, part mass 18c, and part dimensions 18d. Also, the mount-setting calculating unit 162 causes the value stored in the last row of the suction nozzle type (10b) to be displayed in suction nozzle type 18e, and causes the value stored in the motion acceleration (10c) to be displayed in motion acceleration 18f.

The examples of FIGs. 17 and 18 describe that, regarding the settings for a new part ("NCA10"), in consideration of the possibility of occurrence of anomalies, a type "Type 1" is selected from among the suction nozzle candidates ("Type 1" to "Type 3"), and the motion acceleration (a) of the corresponding portion (the head 121) is controlled with 4.0.

### [Learning Process]

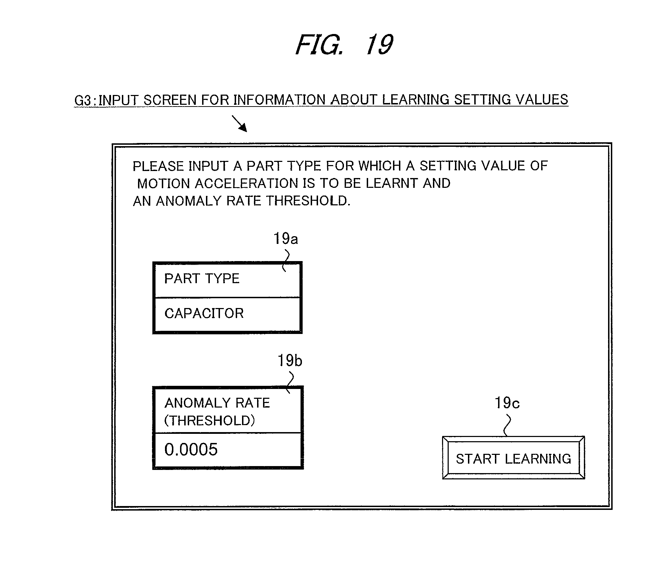

Next, based on the flow of FIG. 7, also with reference to an example of a screen of FIG. 19, a process of updating the area-to-mass ratio acceleration information 192 (FIG. 12) is described in detail as a process by the computing device 150 (the learning processing unit 163) . By updating the area-to-mass ratio (s/m) for the motion acceleration (a) with the use of the information about previously-mounted parts, accuracy in calculation of mount settings is increased.

The computing device 150 (the computation control unit 161) accepts an input of information about learning setting values via the input unit 153 or the I/F unit 155 from the user through a screen G3 of FIG. 19. When the information about the learning setting values is inputted, the learning processing unit 163 is caused to perform the processing of FIG. 7.

FIG. 19 illustrates the screen G3 (an input screen for information about the learning setting Values). The information about the learning setting values to be inputted on the screen G3 has information indicating the part type to be inputted to a field of part type 19a and information about a threshold of an anomaly rate to be inputted to a field of anomaly ratio (threshold) 19b. When an icon 19c indicating "start learning" is clicked, the information about the learning setting values is transmitted (inputted) to the computing device 150 (the learning processing unit 163). In the example of FIG. 19, to learn a value of the motion acceleration (a) for the part with its part type being a capacitor, the anomaly rate threshold is set at 0.0005.

(S21) First, at S21, the learning processing unit 163 calculates an anomaly incidence rate. For example, for each of the rows from the first row to the last row in the table (FIG. 10) for the part information 183, the learning processing unit 163 reads information stored in the number of times of being sucked (10d) and the number of times of anomalies (10e), calculates a value (10e/10d) by dividing the number of times of anomalies 10e by the number of times of being sucked 10d, and stores the resultant value in the anomaly rate (10f).

(S22) At S22, the learning processing unit 163 determines a value of the motion acceleration (a) to be calculated with which the area-to-mass ratio acceleration information 192 (FIG. 12) is updated. For example, if an integer k is not defined, the integer k is defied as k = 1. If the integer k is defined, k = k + 1 is set. Then, a value stored in a k-th row of the motion acceleration (12b) is read (the value is assumed to be d221). (S23)At S23, the learning processing unit 163 divides values (area-to-mass ratio: s/m) obtained by dividing the area (s) of the suction hole 126 of the nozzle 123 by the mass (m) of each part into a plurality of sections, and calculates, for each section, a ratio of the number of data with a small anomaly rate occupying the total number of data. For example, information about the part type to be inputted to a box 19a on the screen G3 (the information is assumed to be d231) and information about an anomaly rate threshold to be inputted to a box 19b (the information is assumed to be d232) are read.

Furthermore, for each row in the table (FIG. 16) for the data ratio information 196, the learning processing unit 163 calculates information from the table (FIG. 10) for the part information 183, and performs the following calculation (here, among the rows in the table for the data ratio information 196, a row of calculation target is referred to as an n-th row).

Among the rows from the first row to the last row in the table (FIG. 10) for the part information 183, the learning processing unit 163 calculates the number of rows satisfying the condition that the value stored in the part type (10g) is equal to d231, the value stored in the motion acceleration (10c) is equal to d221, and the value stored in the area-to-mass ratio (10i) is equal to or larger than the value stored in the n-th row of the section lower limit (16a) in the table (FIG. 16) for the data ratio information 196 and smaller than the value stored in the n-th row of the section upper limit (16b) therein, and then stores the calculated value in the n-th row of the total number of data (16c).

Still further, among the rows from the first row to the last row in the table (FIG. 10) for the part information 183, the learning processing unit 163 calculates the number of rows satisfying the condition that the value stored in the part type (10g) is equal to d231, the value stored in the motion acceleration (10c) is equal to d221, the value stored in the area-to-mass ratio (10i) is equal to or larger than the value stored in the n-th row of the section lower limit (16a) and smaller than the value stored in the n-th row of the section upper limit (16b), and the value stored in the anomaly rate (10f) is equal to or smaller than d232, and then stores the calculated value in the n-th row of the number of data with anomaly rates within thresholds (16d).

Furthermore, the learning processing unit 163 calculates a value by dividing the value stored in the n-th row of the number of data with anomaly rates within thresholds (16d) by the value stored in the n-th row of the total number of data (16c), and then stores the calculated value in the n-th row of the ratio of data with anomaly rates within thresholds (16e). Note that, when the value stored in the n-th row of the total number of data (16c) is smaller than a threshold set in advance (for example, 5), the learning processing unit 163 stores a value stored in an adjacent row (for example, a value stored in an (n-1)-th row or an (n+1)-th row of the ratio of data with anomaly rates within thresholds (16e)) in the n-th row of the ratio of data with anomaly rates within thresholds (16e).

(S24) At S24, the learning processing unit 163 uses the data ratio information 196 to update the area-to-mass-ratio acceleration information 192 (information about the area-to-mass ratio (s/m)). For example, sequentially from the first row in the table (FIG. 16) for the data ratio information 196, the learning processing unit 163 determines whether the value stored in the ratio of data with anomaly rates within thresholds (16e) is equal to or larger than a threshold set in advance (for example, 0.95) and, when determining that the value is equal to or larger than the threshold, reads the value (which is assumed to be d241) stored in the row of the section upper limit (16b). The area-to-mass ratio (s/m) read here indicates that anomalies have occurred less in the previous mounting with a combination of a part and the nozzle 123 with this area-to-mass ratio (s/m). For this reason, even when mounting is next performed with a combination of another part and the nozzle 123, the part mounting can be performed without anomalies (with less anomalies) as long as the area-to-mass ratio (s/m) of the combination is equal to or larger than the area-to-mass ratio (s/m) read here.

Still further, in the table (FIG. 12) for the area-to-mass ratio acceleration information 192, the learning processing unit 163 specifies a row in which the same value as d231 is stored in the part type (12a), and stores d241 in a cell at a position in the row and the k-th column of the area-to-mass ratio (12c).

(S25) At S25, the learning processing unit 163 determines whether the processing (calculation) by the learning processing unit 163 has been completed or not. For example, when the value of the integer k representing a column number for calculation is equal to the number of columns of the motion acceleration (12b) in the table (FIG. 12) for the area-to-mass-ratio acceleration information 192, the learning processing unit 163 ends the process. When the k value is smaller than the number of columns of the motion acceleration (12b), the procedure returns to S22 to similarly continue the process.

According to the learning processing of FIG. 7, for the specified part type (for example, a capacitor), in consideration of the anomaly rate (the data ratio information 196), the setting value of the motion acceleration (a) can be corrected to an appropriate value.

### [Effects and others]

As has been described in the foregoing, with the part (the new part), the nozzle type, and others being taken as input information, particularly based on the ratio (s/m) between the nozzle suction hole area (s) and the part mass (m), the part-mounting device 100 (the computing device 150) according to the present embodiment suitably calculates the type of the nozzle 123 for use in mounting the part, the motion acceleration (a) of the corresponding portion (such as the head 121), and others so as to prevent the occurrence of anomalies due to shortage of the suction force of the nozzle 123, allowing reduction of the anomaly incidence rate.

A comparison is now made with the conventional-art examples. Patent Documents 1 and 2, for example, are not provided with a function of calculating the motion acceleration or the like with taking the part, the nozzle type, and others as input information. Moreover, while the area of the contact surface (other than the suction hole) of the nozzle (a corresponding bottom surface of the part) is used to calculate the motion acceleration in Patent Document 2, the motion acceleration (a) and others are calculated in the present embodiment by using the nozzle suction hole area (s). The present invention is configured as described above considering that the portion of the part-mounting device 100 can be moved with a larger motion acceleration (a) when the part is sucked strongly by the nozzle 123 and the magnitude of the force of sucking the part is in proportion to the nozzle suction hole area (s).

Furthermore, Patent Documents 1 and 2, for example, are not provided with a function of correcting the expressions for use in calculating the motion acceleration by using information about anomalies that have occurred at the time of mounting. In the present embodiment, however, as in FIG. 7, a learning process using the information about anomalies can be performed. For example, when the nozzle is worn out to decrease friction, the part-mounting device is required to be operated with a motion acceleration smaller than that before worn-out, in order not to cause an anomaly. As such, it can be considered that changing the expressions for calculating the motion acceleration or the like according to the state of use of the part-mounting device is necessary or effective. However, in the conventional-art examples, no such changes or calculations are performed. By contrast, they can be performed in the present embodiment.

In the foregoing, the invention made by the inventors of the present invention has been concretely described based on the embodiments. However, it is needless to say that the present invention is not limited to the foregoing embodiments and various modifications and alterations can be made within the scope of the present invention.

The present invention can be used in a production management system and others.

## Claims

1. A computing device determining settings for operation control of a part-mounting device that mounts a part on a substrate, the computing device comprising:
a control unit computing information for the settings; and
a storage unit storing data information for use in the computation, wherein
the storage unit stores:
part information including information about a mass of the part or information from which the mass can be calculated; and
nozzle information including information about an area of a suction hole of a nozzle for use in sucking the part or information from which the area can be calculated, and,
based on the information stored in the storage unit,
by using a ratio between the area of the suction hole of the nozzle and the mass of the part,
the control unit performs a processing of calculating a motion acceleration or a motion speed of a portion of the part-mounting device associated with the nozzle when the nozzle is used for sucking the part.

2. The computing device according to claim 1, wherein
the nozzle information includes information about a plurality of nozzles as candidates for use in mounting the part, and,
for each of the plurality of nozzles as the candidates, the control unit calculates the motion acceleration or the motion speed of the portion of the part-mounting device when the nozzle is used for sucking the part, and,
from among the candidates, the control unit selects a nozzle with a largest motion acceleration or motion speed as a nozzle for use in sucking the part.

3. The computing device according to claim 1, wherein
the part information includes information about a dimension including at least any of a width, a length, and a thickness of the part, and the nozzle information includes information about a diameter of the suction hole of the nozzle, and,
by using a difference between the dimension of the part and the diameter of the suction hole of the nozzle,
the control unit performs a first process of determining adequacy as to whether the nozzle is available for sucking the part and determines the settings by using the determination result.

4. The computing device according to claim 1, wherein,
by using a ratio between the mass of the part and the area of the suction hole of the nozzle,
the control unit performs a second process of determining adequacy as to whether the nozzle is available for sucking the part and determines the settings by using the determination result.

5. A computing device determining settings for operation control of a part-mounting device that mounts a part on a substrate, the computing device comprising:
a control unit computing information for the settings; and
a storage unit storing data information for use in the computation, wherein
the storage unit stores:
part information including information about a mass or a dimension of the part; and
nozzle information including information about an area or a diameter of a suction hole of a nozzle for use in sucking the part, and
based on the information stored in the storage unit, for each of a plurality of nozzles as candidates for use in sucking the part, the control unit performs:
(1) a processing of determining adequacy as to whether the nozzle is available for sucking the part by using a comparison between the area of the suction hole of the nozzle and the mass of the part or a comparison between the diameter of the suction hole of the nozzle and the dimension of the part;
(2) a processing of calculating a motion acceleration or a motion speed of a portion of the part-mounting device associated with the nozzle when the nozzle is used for sucking the part by using a ratio between the area of the suction hole of the nozzle and the mass of the part; and
(3) a processing of selecting, from among the candidates, a nozzle determined as being available and with a largest motion acceleration or motion speed as a nozzle for use in sucking the part.

6. The computing device according to claim 1, wherein
the part information includes information indicating types of the part, and
the control unit performs a processing of calculating the motion acceleration or the motion speed for each of the types of the part.

7. The computing device according to claim 1, wherein
the nozzle information includes information indicating types of the nozzle, and
the control unit performs a processing of calculating the motion acceleration or the motion speed for each of the types of the nozzle.

8. The computing device according to claim 1, wherein
the storage unit stores: first part information including information about a mass of a first part to be newly used or information from which the mass can be calculated; first nozzle information including information about an area of a suction hole of a first nozzle as a candidate for use in sucking the first part; second part information including information about a mass of a second part previously used for mounting; and second nozzle information including information about an area of a suction hole of a second nozzle used for sucking the second part or information from which the area can be calculated, and,
by using a ratio between the area of the suction hole of the second nozzle and the mass of the second part and a ratio between the area of the suction hole of the first nozzle and the mass of the first part,
the control unit performs a processing of calculating a motion acceleration or a motion speed of a portion of the part-mounting device associated with the first nozzle when the first nozzle is used for sucking the first part.

9. The computing device according to claim 1, wherein
the storage unit stores: first part information including information about a mass of a first part to be newly used or information from which the mass can be calculated; first nozzle information including information about an area of a suction hole of a first nozzle as a candidate for use in sucking the first part; second part information including information about a mass of a second part previously used for mounting; second nozzle information including information about an area of a suction hole of a second nozzle used for sucking the second part or information from which the area can be calculated; and information about an anomaly rate of anomalies occurring when the second part previously used for mounting is sucked by the second nozzle, and,
by using a ratio between the area of the suction hole of the second nozzle and the mass of the second part, the information about the anomaly rate, and a ratio between the area of the suction hole of the first nozzle and the mass of the first part, the control unit performs a processing of calculating the motion acceleration or the motion speed of the portion.

10. The computing device according to claim 1, wherein
the part information includes information about a dimension indicating a volume or a width, a length, and a thickness of the part, information indicating a type of the part, and information indicating a density of the part for each type or dimension of the part, and,
by using the dimension and the density of the part, the control unit performs a processing of calculating the mass of the part.

11. A part-mounting device mounting a part on a substrate, the part-mounting device comprising:
a computing device determining settings for operation control of the part-mounting device;
a supply device supplying the part;
a placing device including a nozzle sucking the part and a head having the nozzle; and
an overall control device controlling an operation of each portion of the supply device and the placing device, the operation including an operation of causing the part to be sucked by the nozzle and placing the part on the substrate, according to information about the settings calculated by the computing device, wherein
the computing device includes a control unit that computes the information about the settings and a storage unit that stores data information for use in the computation,
the storage unit stores:
part information including information about a mass of the part or information from which the mass can be calculated; and
nozzle information including information about an area of a suction hole of a nozzle for use in sucking the part or information from which the area can be calculated, and,
based on the information stored in the storage unit,
by using a ratio between the area of the suction hole of the nozzle and the mass of the part,
the control unit performs a processing of calculating a motion acceleration or a motion speed of a portion of the part-mounting device associated with the nozzle when the nozzle is used for sucking the part, and
sets the information about the settings including the calculated information to the overall control device or outputting the information about the settings including the calculated information to a user.

12. A program causing a computer to perform an information processing for determining settings for operation control of a part-mounting device that mounts a part on a substrate,
the program using part information and nozzle information as input information, the part information including information about a mass of the part or information from which the mass can be calculated, and the nozzle information including information about an area of a suction hole of a nozzle for use in sucking the part or information from which the area can be calculated; and
calculating a motion acceleration or a motion speed of a portion of the part-mounting device associated with the nozzle when the nozzle is used for sucking the part, by using a ratio between the area of the suction hole of the nozzle and the mass of the part.
